# EUROPEAN PATENT SPECIFICATION

(11) **EP 0 711 103 B1**
(45) Date of publication and mention of the grant of the patent: **08.03.2000**
(21) Application number: 94308064.8
(22) Date of filing: 02.11.1994
(51) Int. Cl.: H05K 3/30, H05K 3/32

(54) **Surface mount assembly of devices using AdCon interconnections**
Anordnung für die Oberflächenmontage von Vorrichtungen mit leitfähigen Klebstoffverbindungen
Ensemble de montage en surface de dispositifs utilisant des interconnexions AdCon

(43) Date of publication of application: 08.05.1996
(73) Proprietor: AT&T Corp., New York, NY 10013-2412 (US)
(72) Inventor: Dahringer, Donald William, Glen Ridge, New Jersey 07028 (US); Lyons, Alan Michael, New Providence, New Jersey 07974 (US)
(74) Representative: Johnston, Kenneth Graham

(56) References cited:
- WO-A-93/05634
- NL-A- 8 801 448
- US-A- 3 388 465
- US-A- 3 700 226

## Description

### Field of the Invention

This invention concerns process of surface mount assembly of devices using AdCon interconnections.

### Background of the Invention

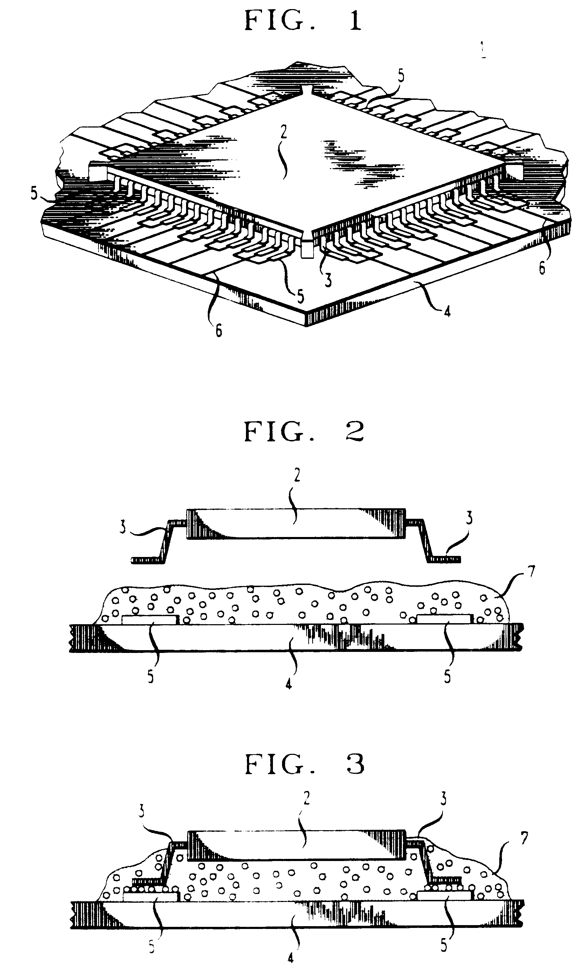

Electrically conductive adhesives are widely used in the electronics industry. Important applications include die-attach and assembly of printed wiring boards (PWBs). An example of a device, 2, with a quad arrangement of leads, 3, surface mounted on a PWB, 4, to a corresponding plurality of conductor pads, 5, which, in turn, are connected to conductors, 6, on the PWB forming a part of a larger assembly, 1, is shown schematically in FIG. 1. As device dimensions continue to shrink, the numbers of leads on devices to be connected to the PWBs continue to increase and the distance between centers of adjacent leads or pads (known as a "pitch") continues to decrease, it becomes more difficult to accurately place isotropically conductive adhesives without shorting adjacent leads. An alternative approach is to use anisotropically conductive adhesives which conduct only in the direction perpendicular to the board (z-direction).

Anisotropically conductive adhesives, hereinafter called AdCons (for Adhesive Connectors), is a class of electrically conductive adhesive materials formulated on the "bridging" concept. The materials are prepared by dispersing electrically conductive particles in an insulating polymer matrix forming an adhesive composite. Typically, the adhesive composite is applied to the surface of a PWB by stencil printing, screen-printing or laminating a film of the conductive adhesive. A schematic representation of a portion of PWB, 4, with conductor pads 5, a region of AdCon, 7, on the PWB and a device 2 with leads 3 to be connected to the conductor pads, is shown in FIG. 2. After the device is placed onto the PWB and a placement force displaces the AdCon from between the conductor pads on the PWB substrate and the leads on the device, a layer of AdCon with a thickness of a single particle remains between each lead and conductor pad, as is shown schematically in FIG. 3. Individual particles span the gap between the device and PWB and form an electrical interconnection. Similarly, semiconductor chips with conductive pads may be surface mounted on the PWB.

In the past, the formation of AdCon interconnections was typically conducted via serial processes where each package was aligned, placed under pressure, and cured individually in a curing oven. Examples of such processing may be seen from U.S. Patent 4,667,401 issued on May 26, 1987 and U.S. Patent 4,868,637 issued on September 19, 1989, both to James R. Clements et al, or from an article by Brian Sun "'The Paste Connector' - Vertically Conductive Adhesive", Connection Technology, August 1988, pp. 31-32. However, this type of processing leads to an inadequate control of applied pressure which could vary from insufficient with formation of non-conducting joints to excessive with resultant damage of leads and interconnections. These processes were difficult to implement both for high input/output (I/O) surface-mount packages and for very small chips, not only because of their low throughput, but also because the assembly processes require coplanarity of the PWB, the package, and an assembly implement. Non-planarity in the system can lead to problems with yield and reliability performance. Furthermore, very small semiconductor chips need an application of high forces per small areas, without the danger of damaging the chips. Also, WO-A-93 05634 discusses a process for surface mount assembly of devices using AdCon interconnections according to the prior art portion of claim 1. NL-A-8 801 448 discloses a method for surface mount assembly of print cards. Therefore, there is a need for an efficient manner for overcoming the above-noted problems, including a need for a process of applying a pressure uniformly across a device or devices of differing dimensions and heights, as well as for an apparatus for implementing the process.

According to the present invention, there is provided a method as defined in claim 1.

This invention is a process of batch assembly of sundry leaded or padded devices, encapsulated and non-encapsulated, onto an interconnection substrate, such as a printed wiring board (PWB), which exhibits significant improvements in both manufacturability and reliability. A pressure frame assembly apparatus permits an application of uniformly distributed pressures to a variety of leaded packages and padded semiconductor chips during cure of conductive adhesives (AdCons), and leads to the reduction of variations in initial interconnection resistance, and thereby to the enhancement of the reliability of AdCon interconnections. The pressures are applied to the devices by an external application of a fluid under pressure to a flexible, resiliently stretchable membrane which conformably envelops outlines of the devices ad adjacent areas of the PWB. Application of vacuum suction to within the cavity, formed by the pressure frame and the membrane, prior to the external application of the fluid pressure to the membrane, further improving the reliability of surface mounted assembly of packages on the interconnection board. The external application of pressure enhances thermal conductivity needed for curing the AdCon, increases the range of processing parameters usable for this technique and reduces assembly times. Assembly yields approaching 100% were observed for a variety of surface mounted packages indicating that the system will be highly reliable.

### Brief Description of the Drawings

FIG. 1 is a schematic perspective representation of a portion of a PWB and of a quad device surface-mounted on the PWB;
FIG. 2 is a schematic representation of a section of a PWB with a thin layer of AdCon thereon and a leaded conductive element prior to the assembly;
FIG. 3 is a schematic representation of the arrangement shown in FIG. 2 but with conductive elements (pads) on the PWB in electrical contact with leads of the device via conductive particles of the AdCon after an application of pressure;
FIG. 4 is a frontal schematic exploded view of a cross-section of the pressure frame apparatus used for the batch assembly of AdCon interconnections;
FIG. 5 is a frontal schematic view of a cross-section of the pressure frame apparatus of FIG. 4 but shown in a closed, operating position;
FIG. 6 is a schematic perspective exploded view of the apparatus shown in FIG. 4;
FIG. 7 is a schematic perspective view of the apparatus shown in FIG. 5;
FIG 8 is a schematic perspective representation of a portion of a PWB with a quad device surface mounted on the PWB and a cable pigtail connection to the device;
FIG. 9 is a schematic perspective view of the apparatus shown in FIG. 6 including a cable pigtail connection;
FIG. 10 is a frontal schematic exploded view of a cross-section of a vacuum-pressure frame apparatus; and
FIG. 11 is frontal schematic view of a cross-section of the vacuum-pressure frame apparatus of FIG. 10 shown in a closed operating position.

### Detailed Description

The assembly of electronic circuits with electrically anisotropic conductive adhesives (AdCons) versus the solder technology offers numerous advantages for the manufacture of PWBs as well as for the effect on the environment. Low temperatures required to cure the adhesives minimize damage, both thermal and physical, to packages and PWBs. Adhesive systems permit the assembly of fine pitch components without the formation of solder shorts or insufficients, and lead to a reduced cost assembly processing. Environmentally, anisotropically conductive adhesives eliminate the need for cleaning flux residues with environmentally harmful chemicals, such as chlorofluorocarbons (CFCs), and reduce worker exposures to lead from molten wave solder baths or reflow ovens.

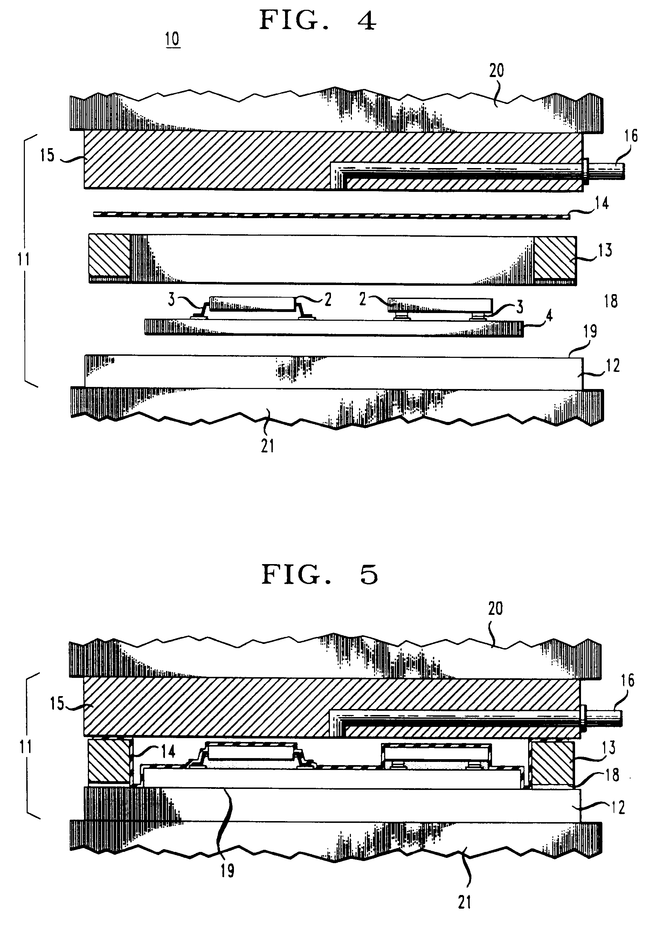

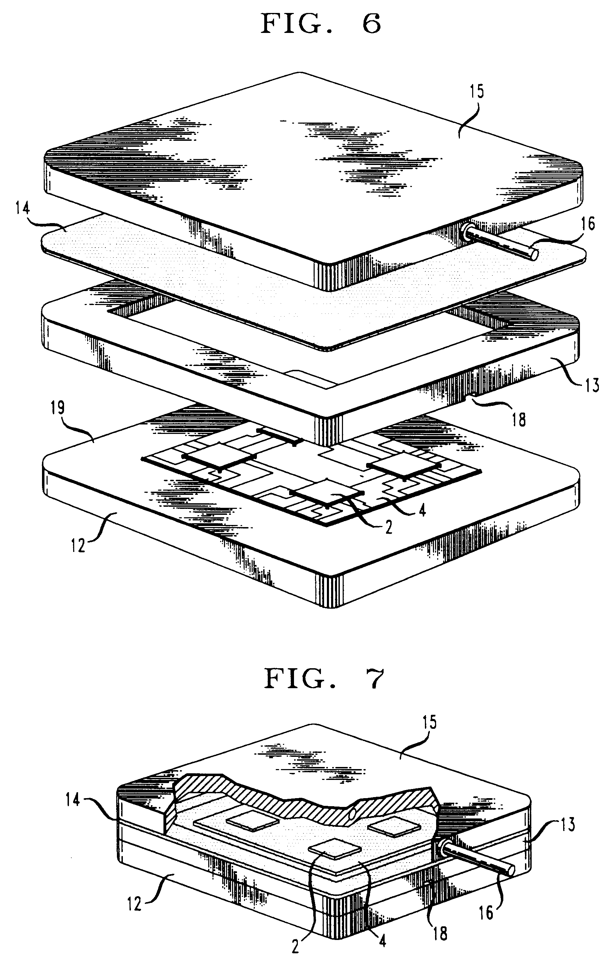

An apparatus known from WO-A-9305634 is schematically represented in FIGs. 4 and 5. Corresponding perspective views of the apparatus are also shown in FIGs. 6 and 7, respectively. For reasons of clarity the elements of the apparatus and the devices are not drawn to scale. The apparatus, shown in an exploded view in FIG. 4 and generally denoted by numeral 11, includes a base, 12, a spacer, 13, a membrane, 14, and a lid, 15, provided with an inlet, 16, for introducing a suitable fluid, such as air, under pressure on top of cover 14. Membrane 14 is of flexible, resiliently stretchable material, such as polysiloxane rubber; secured at the periphery between the spacer and the lid. When subjected to pressure by introduction of fluid into the restricted volume, bounded by the membrane and the lid, the membrane complyably conforms to the outlines of the surfaces of devices, leads and adjacent surfaces of the PWB on the base 12. Care should be taken that the membrane, prior to the application of the pressure, evenly spans the space above the devices, preferably in a taut manner, without kinks and wrinkles which could affect the conformity of the cover with the PWB and devices. Spacer 13 is provided with at least one exhaust port 18, permitting expulsion of air from beneath cover 14. Spacer 13 is provided as a removable unit, primarily for the purposes of facilitating cleaning of floor, 19, of base 12. However, spacer 13 may be secured to base 12 either permanently or removably. A grid (not shown) may be provided, optionally, on or in the floor, 19 of base 12. The grid could be in the form of a screen or an array of rods on the floor or a grating formed in or on the floor of the base, and others. The main purpose of the grid is to reduce the possibility of presence of air pockets between the bottom of the PWB and the floor of the base, and to facilitate removal of the PWBs from the base after the application of pressure and heat.

Introduction of the fluid under pressure leads to a tendency for component parts of apparatus, 11, e.g. base 12 and lid 15, to separate each from another. Therefore, the apparatus should be provided with some means to keep the parts together. The apparatus may be held together by means of clamps or bolts or some other securing means. However, these may be cumbersome to use and assemble, and may present a danger of failure. A viable alternative could be the use of a simple press, such as a bookbinder's press, operable in a suitable manner, e.g. by means of a vertical screw or a lever. A more viable alternative would be the use of an industrial type of a press, such as a laminating press.

In the preferred embodiment, apparatus 11 is positionable between an upper and a lower platens 20 and 21, respectively, of a typical laminating press (not shown). The pressure exhibited by the press by the press transversely of the apparatus should be sufficient to keep parts of the apparatus together and to prevent leakage of the fluid between the membrane and the lid, but not so great as to damage portions of membrane 14 located between adjacent portions of the spacer and the lid. Base 12, spacer 13 and the flexible membrane 14 are removable from the press for the purposes of placing on the base articles to be processed and removing the processed articles. Lid 15 may be also removable from the press along with the rest of the apparatus. Alternatively, lid 15 may be secured to and shall be movable vertically with upper platen 20 of the press. Also, base 12 may be secured to lower platen 21. In the preferred embodiment, spacer 13 is removable from base 12; however, spacer 13 may be secured on the base. Alternatively, spacer 13 may be attached to upper platen 20 and may be moved vertically with the lid. In the latter instance, arrangements should be made for securing membrane 14 between the spacer and the lid or for being capable of replacing the membrane as needed. This could necessitate attachment of spacer 13 removably to the lid.

The size of apparatus 11 may be sufficient to accommodate only one PWB. Alternatively, it may be of a size capable of accommodating several PWBs or PWB sheets which are each a multiple of several standard PWB's in size, and may be limited only by the size of the laminating press.

In operation, an assembly of a PWB, AdCon on the contact pads of the PWB, and at least one device (or semiconductor chip) with leads (or pads) in contact with the AdCon is placed onto floor 19 of base 12, spacer 13 is placed onto the peripheral section of base 12, membrane 14 is placed onto the spacer 13 enclosing a cavity formed by the base and the spacer, and lid 15 is placed over the membrane 14 securing the peripheral area of the membrane between the spacer and the lid. Thereafter apparatus 11 is placed onto lower platen 21, and the press is activated to bring platen 20 in contact with the lid. A suitable fluid, such as air, under pressure is introduced on top of membrane 14 via inlet 16, forcing cover 14 in conforming contact with the device or devices and with exposed upper surface of the PWB and of base 12. The pressure is preselected to force the devices toward the PWB so as to displace an excess of the adhesive from between contacting surfaces of the leads or pads 3 on the devices and pads 5 on the PWB leaving a thin adhesive layer in a thickness of a single particle, with particles in the adhesive layer forming an electrical connection between the contacting surfaces. However, the pressure should not be so excessive as to cause any damage to the device, e.g. to flatten, bend or even break off the leads.

The fluid is applied onto membrane 14 via inlet 16 connected to a suitable source (not shown) of pressurized fluid, e.g. air, forcing the membrane toward the PWB and devices thereon. The pressure exerted by the membrane onto the devices should only be sufficient to bring the leads (or pads) in contact with the metal particles in the AdCon so as to establish continuous conductive paths between the leads (or pads) of the device and the metallizations on the PWB without causing any damage to the assembly. Commercially available air compressor capable of providing pressure required for the bonding purpose, would be useful as the source of air pressure. A fluid pressure within a range of from 3·45 x 10⁴ N/m² to 3·45 x 10⁶ N/m². (5 to 500 psi) could be applied to the membrane. The actual pressure acting on the devices via the membrane is somewhat greater than the applied pressure being a combination of the pressure due to the applied pressure and due to forces exhibited by stretching of the membrane. Typically fluid pressures ranging from (5 and 25 psi) 3·45 x 10⁴ N/m² to 1·72 x 10⁵ N/m² preferably 1·03 x 10⁵ N/m² (15 psi,) are sufficient for most of IC package applications. An exception could be extremely small packages, such as non-encapsulated semiconductor chips, e.g. 1/8th an inch square or smaller, which may require application of higher pressures e.g. of the order of (200-300 psi) 1·38 x 10⁶ N/m² to 2·07 x 10⁶ N/m².

In an exemplary embodiment, the polymer matrix for the AdCon used for these experiments was prepared from diglycidyl ether of bisphenol F (Dainippon Ink and Chemical Co., Epiclon 830®). A fumed silica thixotrope (Cabot, TS-720) was dispersed in the epoxy resin with a Waring® blender at a concentration of 5 parts per hundred resin (phr). Thixotrope concentrations ranging from 1 to 10 parts per hundred resin may be useful. To aliquots of this mixture, 10 phr of a 2-ethyl,4-methylimidazole curing agent (Pacific Anchor Chemical, EMI-24) was added along with conductive particles. For the successful implementation of AdCon, the concentration of metal particles must be controlled such that a sufficient number of particles is present in the adhesive composite to assure reliable electrical conductivity between the PWB and the leads or pads of the device (z-direction), while electrical isolation is maintained between adjacent conductor pads and leads (x-y direction). Actually, one should strive for such required volume concentration of metallic particles in the adhesive composite which will provide a maximum amount of conductive particles without causing any shorts between adjacent leads 3 or adjacent conductor pads 5. In addition, adequate adhesive performance is necessary to maintain a mechanically robust interconnection. The formulations were mixed by hand and degassed under vacuum (15 micrometers of Hg) 2 N/m² for 30 minutes before use. In the exemplary embodiment, the particles were silver plated glass spheres from 8 to 20 µm in size with an average diameter of 14 µm (obtainable from Potters Industries). They were added in an amount of from 10 to 15 volume % (26 to 32 wt. %), preferably 12.5 volume % (29 wt. %).

Assembly of packages on test PWBs was achieved by following a multistep process. The AdCon was mixed, degassed and stenciled onto a PWB in a thickness of about 2 mils using a doctor blade and shims or in a thickness of about 5 mils by means of a manually operated stencil printer (Henry Mann AP-810). Some of the packages were placed onto the stenciled PWBs manually and some using an appropriate tool (e.g. Manix or a Single Site Solder Machine or [SSSM]). Assembled boards were placed into apparatus 11 which was then placed between platens 20 and 21 where the adhesive interconnection was cured under heat and pressure as illustrated in FIG. 5.

The PWB is heated primarily from the bottom of base 12 at a temperature ranging from 100 to 350 °C, preferably 125 °C. Higher temperatures may be useful depending on the components, adhesive matrix formulations, and cure speed requirements. Heat may be supplied in a variety of ways, such as a) hot plates positioned between base 12 and lower platen, 21; b) heating coils embedded in the base; or c) suitable heating means provided in the lower platen, e.g. heating coils, electrical, hot water or steam heating to provide heat within the desired range. Additional heating may be provided from the top of the apparatus in the manner similar to that for heating the bottom portion of the apparatus. However, the overhead heating need to be only a fraction of that needed for the bottom heating and is primarily to avoid cooling of base 12 and lower platen 21 by parts of the apparatus, e.g. lid 15 and upper platen 20, so as to avoid increase in the curing time. The overhead heating temperature may range from 30 to 350 degreesC, and is preferably 55 °C. Alternatively, the heating arrangement may be reversed, with the higher preferred temperatures being applied from above and the lower from below apparatus 11.

Pressure is applied to the assembly on the base by means of flexible stretchable membrane 14 positioned over the cavity formed by base 12 and spacer 13. The pressure exerted by the fluid onto membrane 14 stretches the membrane and forces it into a conformable contact with the packages. The membrane should be sufficiently stretchable to conform under pressure about the individual package dimensions, thus insuring uniform pressure application in the direction normal to the PWB. The member should be of such resilient material as to permit the member to return to its original unstretched position upon removal of forces applied by the fluid. A wire screen, used as a grid separating the PWB from the heated base, prevents the membrane from sealing off access to exhaust port 18 in spacer 13. Cure times of from 30 seconds to 60 minutes, with 2 to 4 minutes being average, were used for each assembly curing operation.

The versatility of the above apparatus was tested using devices with a variety of leads or connections. These included 100 two-leaded discrete resistors, 12 14-leaded Small Outline Integrated Circuits (SOICs) with 50 mil pitch solder plated gull-wing leads, and 45 132-leaded daisy-chained Plastic Quad Flat Packages (PQFPs) with 25 mil pitch solder plated gull-wing leads (a total of 3,148 interconnections). PWBs used were fire resistant grade 4 (FR-4) boards made of glass fiber reinforced epoxy, clad with copper foil and coated with solder.

The resistors, SOICs and PQFPs, assembled and cured as described above, were tested for shorts and interconnections. Assembly yields of 100% of viable interconnections were observed for all packages. A viable interconnection was defined as one having a resistance value of < 100 mΩ for two-leaded resistors and 14-leaded SOICs and < 1 Ω (including resistance contributions from the PWB and the internal package daisy chain) per each 16 leads for the 132-leaded PQFPs. No shorts were observed between any of the adjacent leads and pads.

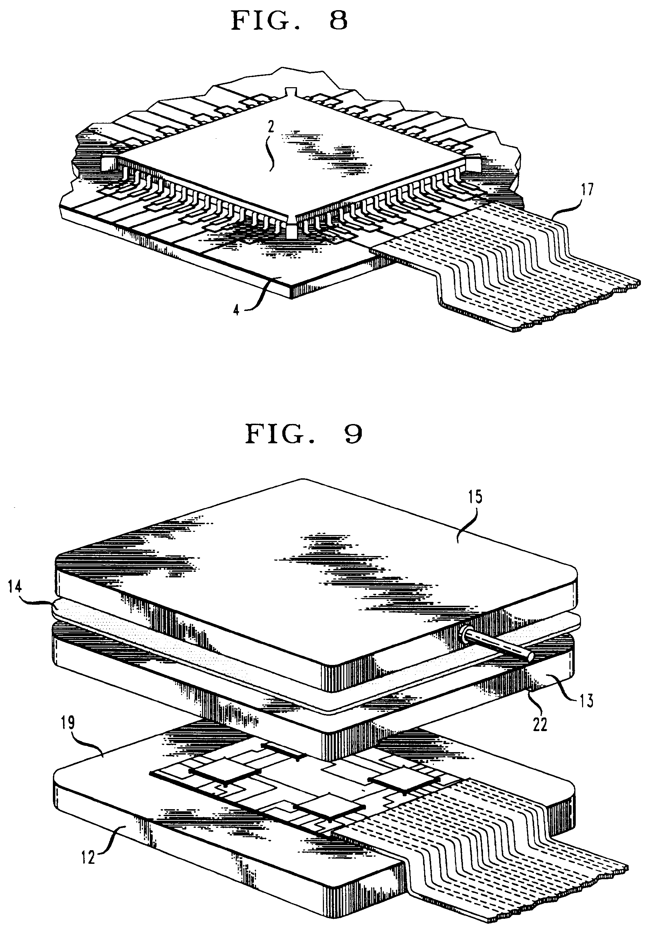

The invention may be used for connection of a flexible flat cable (or cable pigtail) to conductors on a PWB. For example, as shown in FIGs. 8 and 9, an end portion of a flat cable, 17, provided with contacts (not shown) may be connected to conductors 6 on a PWB by means of AdCon deposited on the PWB. In FIG. 8 is shown such a connection to a single device, while in FIG. 9 the cable is connected to at least two devices. When the cable is of such length as to extend beyond the perimeter of apparatus 11, spacer 13 would be provided with an elongated aperture 22, in place of or in addition to exhaust ports 18, permitting the cable to extend through aperture 22 beyond apparatus 11.

In the above-described embodiment, device or devices are held in place by means of the resiliently deformable membrane conformably held against the devices by a fluid pressure applied on top of the membrane. However, with miniaturization, the devices are being reduced in size so that upon application of pressure to the membrane the devices may be dislodged by the membrane being forced against the device and the surface of the interconnection board. The danger of displacement would also arise if the devices would be of disproportionate variation in size and are closely positioned on the interconnection board.

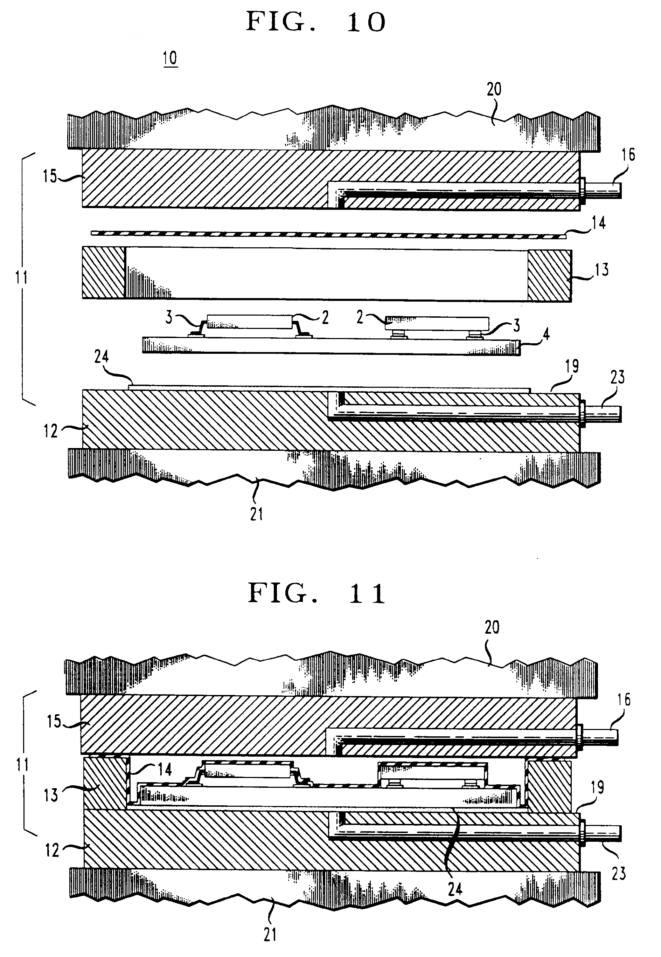

This problem is overcome by providing base 12 with at least one vacuum port, 23, and removal of the exhaust port 18 shown in FIG. 5. The use of vacuum would necessitate the use of the grid, 24, described above. This arrangement is shown in FIGs. 10 and 11. In operation, interconnection board 4 with adhesive and devices 2, is placed upon a grid, 24, within a cavity formed by base 12, spacer 13, membrane 14 and lid 15. After the cavity is enclosed with resilent membrane 14 and 15, a vacuum suction `is applied via vacuum port 23 so as to bring membrane 14 in conformable contact with the device(s) without causing any displacement thereof. The vacuum suction is applied such that the air pressure within the cavity ranges from (-1 to -14.7 psi.) -6·89 x 10³ N/m² to -1·01 x 10⁵ N/m² Thereafter, fluid pressure is applied on top of the membrane sufficiently to effect electrically conductive junction between contacts on the electronic device and contacts on the interconnection board.

Alternatively, the membrane may be composed of two webs of the resilient material. One, inner membrane facing the devices could by a thinner, more easily deformable membrane used for the purpose of conformably shaping about the devices with a minimum of applied suction, and the other upper membrane overlaying the inner membrane being deformable upon application of fluid under pressure.

## Claims

1. A method for mounting at least one electronic device (2) having electrical contacts (3) onto a interconnection substrate (4) having electrical conductors (5) 50 as to establish a electrical interconnection between said contacts (3) and said conductors (5), which comprises the following subsequent steps:
forming a assembly of said at least one device (2) and said interconnection substrate (4) by applying an electrically conductive adhesive (7) over a region on the interconnection substrate, said region including conductors (5) to be electrically connected to contacts (3) of said at least one device (2),
placing said at least one device (2) on the interconnection substrate (4) such that the contacts (3) of said device (2) are in alignment with the conductors (5) in said region of the substrate (4),
enclosing the assembly within a cavity provided with a membrane (14) positioned above the assembly, said membrane (14) being resiliently stretchable so that, upon application of a fluid pressure to the membrane (14) portions of the membrane (14) engage said at least one device (2) forcing the contacts (3) of the device (2) toward the conductors (5) of the substrate (4), and
applying heat and pressure to said at least one device (2) such that said adhesive forms a electrical and mechanical interconnection between contacts (3) of the device (2) and conductors (5) of the substrate (4)
the process being characterised in that prior to applying a fluid pressure to the membrane vacuum suction is applyed to a space within the cavity so as to draw the membrane (14) toward and into engaging contact with said at least one device (2).

2. The method of claim 1 in which the cavity is formed by a base (12), a spacer (13) positioned on a peripheral portion of the base (12), a resiliently stretchable membrane (14) positioned on the spacer (13) and enclosing the cavity, wherein the membrane (14) is suspended above the level of said at least one electronic device (2) and is free of winkles and sags, said base (12) being provided with a outlet (23) for providing vacuum suction from within the space defined by the cavity enclosed by the membrane (14), a solid lid (15) overlying the membrane (14) and securing peripherally the membrane (14) between the spacer (13) and the peripheral region of the lid (15), said lid (15) being provided with a inlet (16) for introducing a fluid under pressure between the lid (15) and the membrane (14) so as to stretch the membrane (14) into a conformable contact with the said at least one device (2), and said vacuum outlet (23) is used for reducing pressure within the cavity to cause the membrane (14) to collapse against said at least one device (2) prior to the application of said fluid pressure to the membrane (14).

3. The method of claims 1 or 2, in which said membrane (14) comprises polysiloxane.

4. The method of claims 1 or 2 or 3, in which the vacuum suction is applied before the pressure is applied between the membrane (14) ad the lid (15).

5. The method of claims 1 or 2 or 3 or 4, in which the vacuum suction within the cavity ranges from -6.89 x 10³ N/m² to -1.01 x 10⁵ N/m².

6. The method of any one of the preceding claims 1-5, in which said pressure is applied to the electronic device (2) by introducing a fluid pressure above the membrane (14) and forcing portions of said membrane (14) toward the device (2).

7. The method of claim 6, in which said fluid pressure ranges from 3.45 x 10⁴ N/m² to 3.45 x 10⁶ N/m², preferably from 3.45 x 10⁴ N/m² to 1.72 x 10⁵ N/m².

8. The method of any one of the preceding claims 1-7, in which said curing of the adhesive is expedited by beating the assembly.

9. The method of claim 8, in which said beating is conducted by heating the assembly from the bottom at a temperature ranging from 100 °C to 350 °C, preferably at about 125 °C.

10. The method of claim 8, in which said heating is conducted by additionally heating the assembly from above at a temperature ranging from 30 °C to 350 °C, preferably at about 55 °C.

11. The method of any one of the preceding claims 1-10, in which the adhesive is selected from an anisotropically conductive adhesive material, a isotropically conductive adhesive material, and a nonconductive adhesive material, and further from thermosetting, thermoplastic and pressure sensitive adhesives.

12. The method of any one of the preceding claims 1-11, in which the interconnection substrate (4) is a printed wiring board.

## Patentansprüche

1. Verfahren zum Befestigen wenigstens einer elektronischen Einrichtung (2) mit elektrischen Kontakten (3) auf einem Verbindungssubstrat (4) mit elektrischen Leitungen (5), um eine elektrische Verbindung zwischen den Kontakten (3) und den Leitungen (5) aufzubauen, welches die nachfolgenden aufeinanderfolgenden Verfahrensschritte umfaßt:
Ausbilden einer Baugruppe aus wenigstens der einen Einrichtung (2) und dem Verbindungssubstrat (4) durch Aufbringen eines elektrisch leitfähigen Klebstoffes (7) über einem Bereich des Verbindungssubstrats, wobei der Bereich Leitungen (5) umfaßt, um elektrisch mit den Kontakten (3) wenigstens der einen Einrichtung (2) verbunden zu werden,
Anordnen wenigstens einer Einrichtung (2) an dem Verbindungssubstrat (4), so daß die Kontakte (3) der Einrichtung (2) zu den Leitungen (5) im Bereich des Trägers (4) ausgerichtet sind,
Einbringen der Baugruppe in eine Kammer, welche mit einer Membran (14) versehen ist, die auf der Baugruppe angeordnet ist, wobei die Membran (14) so elastisch ziehbar ist, daß nach Aufbringen eines Flüssigkeitsdruckes auf die Membran (14) Abschnitte der Membran (14) wenigstens die eine Einrichtung (2) berühren, und die Kontakte (3) der Einrichtung (2) zu den Leitungen (5) des Trägers (4) pressen,
Anwenden von Wärme und Druck auf die wenigstens eine Einrichtung (2), so daß der Klebstoff eine elektrische und mechanische Verbindung zwischen den Kontakten (3) der Einrichtung (2) und den Leitungen (5) des Trägers (4) bildet, wobei das Verfahren dadurch gekennzeichnet ist,
daß vor Aufbringen eines Flüssigkeitsdrucks auf die Membran eine Vakuumabsaugung auf einen Raum innerhalb der Kammer so angewendet wird, daß die Membran (14) in Berührungskontakt mit der wenigstens einen Einrichtung (2) gebracht wird.

2. Verfahren nach Anspruch 1,
bei welchem die Kammer von einer Basis (12) gebildet wird, ein Abstandhalter (13) an einem Randabschnitt der Basis (12) angeordnet ist, die elastische ziehbare Membran (14) am Abstandhalter (13) angeordnet ist und die Kammer umschließt, bei welcher die Membran (14) oberhalb der wenigstens einen elektronischen Einrichtung (12) gehalten wird und frei von Falten und Durchbiegungen ist, wobei die Basis (12) mit einem Auslaßrohr (23) vorgesehen ist, um eine Vakuumabsaugung von innerhalb des Raumes bereitzustellen, welcher durch eine Kammer definiert ist, die von der Membran (14) umschlossen ist, wobei eine feste Abdeckung (15) auf der Membran (14) liegt und die Membran (14) zwischen dem Abstandhalter (13) und dem Randbereich der Abdeckung (15) am Rande sichert, wobei die Abdeckung (15) mit einem Einlaßrohr (16) versehen ist, um unter Druck eine Flüssigkeit zwischen der Abdeckung (15) und der Membran (14) einzuführen, um die Membran (14) in gleichförmigen Kontakt mit der wenigstens einen Einrichtung (12) zu bringen, und das Vakuumauslaßrohr (23) verwendet wird, um den Druck innerhalb der Kammer zu verringern, um zu bewirken, daß sich die Membran (14) vor dem Anwenden des Flüssigkeitsdrucks auf die Membran (14) gegen die wenigstens eine Einrichtung (2) legt.

3. Verfahren nach Anspruch 1 oder 2,
bei welchem die Membran (14) Polysiloxan umfaßt.

4. Verfahren nach Anspruch 1, 2 oder 3,
bei welchem die Vakuumabsaugung angewendet wird, bevor Druck zwischen der Membran (14) und der Abdeckung (15) angewendet wird.

5. Verfahren nach Anspruch 1, 2, 3 oder 4,
bei welchem die Vakuumabsaugung innerhalb der Kammer von -6,89*10³ N/m² bis -1,01*10⁵ N/m² reicht.

6. Verfahren nach einem der vorstehenden Ansprüche 1 bis 5, bei welchem der Druck auf die elektronische Einrichtung (2) durch Aufbringen eines Flüssigkeitsdrucks auf die Membran (14) und durch Preßen der Abschnitte der Membran (14) zur Einrichtung (2) aufgebracht wird.

7. Verfahren nach Anspruch 6,
bei welchem der Flüssigkeitsdruck von 3,45*10³ N/m² bis 3,45*10⁶N/m² reicht und bevorzugt von 3,45*10⁴ N/m² bis 1,72*10⁵N/m² reicht.

8. Verfahren nach einem der vorstehenden Ansprüche 1 bis 7, bei welchem das Aushärten des Klebstoffes durch Erwärmen der Baugruppe beschleunigt wird.

9. Verfahren nach Anspruch 8,
bei welchem das Erwärmen durch Erwärmen der Baugruppe vom Boden her bei einer Temperatur durchgeführt wird, welche von 100°C bis 350°C reicht und bevorzugt bei etwa 125°C liegt.

10. Verfahren nach Anspruch 8,
bei welchem das Erwärmen durch zusätzliches Erwärmen der Baugruppe von oberhalb bei einer Temperatur durchgeführt wird, welche von 30°C bis 350°C reicht und bevorzugt bei etwa 55°C liegt.

11. Verfahren nach einem der vorstehenden
Ansprüche 1 bis 10, bei welchem der Klebstoff aus anisotrop leitfähigem klebfähigem Material, aus isotrop leitfähigen klebfähigen Material, aus nichtleitfähigem klebfähigem Material und/oder weiterhin aus einem thermisch aushärtbaren, und druckempfindlichen Klebstoff ausgewählt wird.

12. Verfahren nach einem der vorstehenden
Ansprüche 1 bis 11, bei welchem der Verbindungssubstrat (4) eine bedruckte Verdrahtungs- oder Leiterplatte ist.

## Revendications

1. Procédé pour monter au moins un dispositif (2) électronique ayant des contacts (3) électriques sur un substrat (4) d'interconnexion ayant des conducteurs (5) électriques, de manière à établir une interconnexion électrique entre les contacts (3) et les conducteurs (5), qui comportent les étapes suivantes en séquence :
formation d'un assemblage dudit au moins un dispositif (2) et du substrat (4) d'interconnexion par application d'un adhésif (7) conducteur de l'électricité sur une région sur le substrat d'interconnexion, la région comportant des conducteurs (5) à connecter électriquement aux contacts (3) dudit au moins un dispositif (2),
placement dudit au moins un dispositif (2) sur le substrat (4) d'interconnexion de sorte que les contacts (3) du dispositif (2) sont alignés avec les conducteurs (5) dans la région du substrat (4),
enfermement de l'assemblage à l'intérieur d'une cavité munie d'une membrane (14) positionnée au-dessus de l'assemblage, la membrane (14) pouvant être étirée de manière élastique de sorte que, lors de l'application d'une pression de fluide à la membrane (14), des parties de la membrane (14) coopèrent avec ledit au moins un dispositif (2) en forçant les contacts (3) du dispositif (2) en direction des conducteurs (5) du substrat (4), et
application de chaleur et de pression audit au moins un dispositif (2) de sorte que ledit adhésif forme une interconnexion mécanique et électrique entre des contacts (3) du dispositif (2) et des conducteurs (5) du substrat (4),
le processus étant caractérisé en ce que, avant l'application d'une pression de fluide à la membrane, une aspiration sous vide est appliquée à un espace à l'intérieur de la cavité de manière à tirer la membrane (14) en direction dudit au moins un dispositif (2) pour l'amener en contact de coopération avec ledit au moins un dispositif (2).

2. Procédé suivant la revendication 1, dans lequel la cavité est formée d'une base (12), d'une entretoise (13) positionnée sur une partie périphérique de la base (12), d'une membrane (14) pouvant être étirée de manière élastique positionnée sur l'entretoise (13) et enfermant la cavité, dans lequel la membrane (14) est suspendue au dessus du niveau dudit au moins un dispositif (2) électronique et n'est pas froissé, ni ne comporte de coulures, la base (12) étant munie d'une sortie (23) pour permettre une aspiration sous vide à partir de l'intérieur de l'espace défini par la cavité enfermée par la membrane (14), un couvercle (15) solide surplombant la membrane (14) et fixant de manière périphérique la membrane (14) entre l'entretoise (13) et la région périphérique du couvercle (15), le couvercle (15) étant muni d'une entrée (16) pour introduire un fluide sous pression entre le couvercle (15) et la membrane (14), de manière à étirer la membrane (14) en un contact convenable avec ledit au moins un dispositif (2), et la sortie (23) de vide est utilisée pour réduire la pression à l'intérieur de la cavité pour faire en sorte que le membrane (14) s'effondre contre ledit au moins un dispositif (2) avant l'application de la pression de fluide à la membrane (14).

3. Procédé suivant la revendication 1 ou 2, dans lequel la membrane (14) comporte du polysiloxane.

4. Procédé suivant la revendication 1, 2 ou 3, dans lequel l'aspiration sous vide est appliquée avant que la pression ne soit appliquée entre la membrane (14) et le couvercle (15).

5. Procédé suivant la revendication 1, 2, 3 ou 4, dans lequel l'aspiration sous vide à l'intérieur de la cavité est comprise entre -6,89 x 10³ N/m² et-1,01 x 10⁵ N/m².

6. Procédé suivant l'une quelconque des revendications 1 à 5 précédentes, dans lequel la pression est appliquée au dispositif (2) électronique en introduisant une pression de fluide au dessus de la membrane (14) et en forçant des parties de la membrane (14) en direction du dispositif (2).

7. Procédé suivant la revendication 6, dans lequel la pression de fluide est comprise entre 3,45 x 10⁴ N/m² et 3,45 x 10⁶ N/m², de préférence entre 3,45 x 10⁴ N/m² et 1,72 x 10⁵ N/m².

8. Procédé suivant l'une quelconque des revendications 1 à 7 précédentes, dans lequel le durcissement de l'adhésif est activé en chauffant l'assemblage.

9. Procédé suivant la revendication 8, dans lequel le chauffage est réalisé en chauffant l'assemblage à partir du fond à une température comprise entre 100°C et 350°C, de préférence à environ 125°C.

10. Procédé suivant la revendication 8, dans lequel le chauffage est réalisé en chauffant de manière additionnelle l'assemblage à partir du dessus à une température comprise entre 30°C et 350°C, de préférence à environ 55°C.

11. Procédé suivant l'une quelconque des revendications 1 à 10 précédentes, dans lequel l'adhésif est sélectionné parmi un matériau adhésif conducteur anisotrope, un matériau adhésif conducteur isotrope et un matériau adhésif non conducteur et en outre parmi des adhésifs thermodurcissables, thermoplastiques et sensibles à la pression.

12. Procédé suivant l'une quelconque des revendications 1 à 11 précédentes, dans lequel le substrat (4) d'interconnexion est une planche de câblage imprimé.
